(19) Europäisches Patentamt
European Patent Office
Office européen des brevets

(11) Publication number: 0 383 536 A2

(12) # EUROPEAN PATENT APPLICATION

(21) Application number: 90301500.6

(51) Int. Cl.5: G03F 7/00

(22) Date of filing: 13.02.90

(30) Priority: 15.02.89 JP 35553/89
28.04.89 JP 110452/89
28.04.89 JP 110453/89

(43) Date of publication of application:
22.08.90 Bulletin 90/34

(84) Designated Contracting States:
DE FR GB

(71) Applicant: SEIKO INSTRUMENTS INC.
31-1, Kameido 6-chome Koto-ku
Tokyo 136(JP)

(72) Inventor: Iwasaki, Fumiharu
c/o Seiko Instruments Inc., 31-1 Kameido 6-chome
Koto-ku, Tokyo(JP)
Inventor: Takahashi, Hiroshi
c/o Seiko Instruments Inc., 31-1 Kameido 6-chome
Koto-ku, Tokyo(JP)
Inventor: Sakoziri, Hiromichi
c/o Seiko Instruments Inc., 31-1 Kameido 6-chome
Koto-ku, Tokyo(JP)

(74) Representative: Caro, William Egerton et al
J. MILLER & CO. Lincoln House 296-302 High Holborn
London WC1V 7JH(GB)

(54) **Thermo-sensitive transfer printing medium.**

(57) A transfer printing medium comprises a heat resistant substrate (2, 102, 202) and a photo- and thermo-sensitive film (10, 11, 110, 111, 210) disposed on the substrate. The film comprises porous micro-capsules (3, 103, 203) containing colouring material (4, 104, 204), and being responsive to thermal energy to release the colouring material, a photo-sensitive resin (6, 106, 206) arranged to undergo photo-polymerisation in response to exposure to light to control the rate of transfer of the released colouring material, and an initiator (7, 107, 207) effective to initiate the photo-polymerisation. The micro-capsules, the resin and the initiator are distributed in a binder (5, 105, 205) for support.

FIG. 1

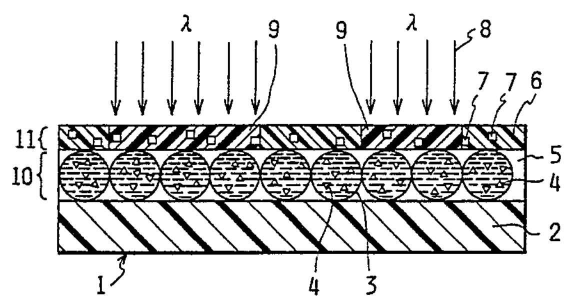


EP 0 383 536 A2

# THERMO-SENSITIVE TRANSFER PRINTING MEDIUM

The present invention relates to a thermo-sensitive transfer printing medium, for example a thermo-sensitive transfer printing sheet.

A conventional thermo-sensitive transfer sheet generally comprises a resin film substrate, such as polyethylene terephthalate (PET), coated with a heat meltable ink composed of colouring material dispersed in a heat meltable binder.

In such a conventional thermo-sensitive transfer sheet, the heat meltable ink is locally heated to melting to transfer the ink from the relevant portion of the substrate to recording paper to effect two-level density printing. Therefore, an area gradation method, such as a dither method or a density pattern method, is utilised to impart gradation in the printed image.

When the area gradation method is employed to obtain a gradated image using the conventional thermo-sensitive transfer sheet, complicated processing of an image signal is necessary and resolution is reduced, thereby reducing the quality of the printed image.

An object of the present invention is to provide a transfer printing sheet, which avoids such problems.

According to the present invention, there is provided a transfer printing medium comprising a heat resistant substrate, and a thermo-sensitive film disposed on the substrate, the film being composed of porous micro-capsules which contain colouring material, and a binder in which the micro-capsules are distributed, the film being responsive to thermal energy to release the colouring material, characterised in that the film is further composed of a photo-sensitive material and is responsive to exposure to light to control the transfer of the released colouring material during printing.

The preferred embodiments of the invention described below are thus both photo- and thermo-sensitive and are capable of providing a continuously gradated printed image of high quality.

As described, the photo-sensitive material preferably comprises a resin which undergoes photo-polymerisation in response to exposure to light to control the rate of transfer of the released colouring material, and an initiator effective to initiate the photo-polymerisation.

A first embodiment of the invention described below features a substrate composed of a heat resistant film, such as polyethylene terephthalate (PET) having a thickness of the order of 10 µm. A first layer formed on the substrate comprises the porous micro-capsules, which contain leuco dye and which are dispersed in a heat meltable binder. A second, photo-sensitive, layer is formed on the micro-capsule layer and is composed of a mixture of the photo-sensitive resin, which can be cured upon exposure to ultra-violet light or visible light, the initiator, and a further binder. The porous micro-capsules are arranged to release the leuco dye in response to thermal energy. On the other hand, the photo-sensitive resin is capable of controlling the transfer of the leuco dye released from the micro-capsules depending on the degree of polymerisation in response to irradiation by the light.

In use, the transfer sheet is irradiated with ultra-violet or visible light modulated according to a video signal from a CRT etc in order variably to polymerise the photo-sensitive resin of the photo-sensitive layer according to the video signal to form therein a latent image. The transfer sheet is then heated by a heat roller or by irradiation by infra-red light so as to transfer the leuco dye through the variably polymerised layer to a recording sheet coated with developer whereby to develop a continuously gradated image according to the video signal and hence achieve a high quality printed image.

In a second embodiment of the present invention described below, there is provided a substrate composed of a heat resistant film, such as polyethylene terephthalate (PET) having a thickness of the order of 10 µm, and first and second layers are again formed on the substrate. In this instance, the first layer comprises the porous micro-capsules, which contain colour dye or pigment and which are dispersed in a heat meltable binder. The second layer is a photo-sensitive layer formed on the micro-capsule layer and comprises a mixture of the photo-sensitive resin, which can be cured upon exposure to ultra-violet light or visible light, the photo-polymerisation initiator, and a further binder. The porous micro-capsules are capable of releasing the colour dye or pigment in response to thermal energy. The photo-sensitive resin is capable of controlling the transfer of the colour dye or pigment released from the micro-capsules depending on the degree of the photo-polymerisation due to irradiation by light. Consequently, the amount of the colour dye or pigment transferred can be effectively controlled according to the energy of the irradiating light.

For example, when the ultra-violet or visible light is modulated according to a video signal from a CRT and is directed onto the photo-sensitive layer, the photo-sensitive resin is locally polymerised and cured for the purpose of controlling the amount of the colour dye or pigment transferred which is released from the micro-capsules. More especially, heating is carried out by a heater, the micro-capsule layer is melted, and the micro-capsules begin to release the colour dye or pigment. The released colour dye or pigment is

transferred to a plain recording paper depending on the portions of the photo-sensitive layer which are locally polymerised. The colour dye or pigment is thus transferred to the recording paper according to the area energy distribution of the irradiating light.

A third embodiment of the present invention described below features a substrate made of, for example PET film, and a single layer formed on the substrate. This layer comprises the porous micro-capsules containing the colouring material, the photo-sensitive resin, the photo-polymerisation initiator, and a heat meltable binder in which the micro-capsules, the resin and the initiator are dispersed. In use, the photo-sensitive resin is selectively cured by irradiation by ultra-violet light or visible light to form cured portions in the layer to produce a latent image. In response to heat applied by a heat generator, the layer is melted so that the micro-capsules release the colouring material. The colouring material is transferred through non-cured portions of the layer to a recording sheet, where the material reacts with a developer coated on the recording sheet to form a printed image. Depending on the degree of the photo-polymerisation, the cured state of the resin may be varied to control the transfer rate of the colouring material so as to effect transfer printing of a continuously gradated image of high quality.

The invention will be described further, by way of example, with reference to the accompanying drawings, in which:-

Figure 1 is a schematic sectional view through a first embodiment of photo- and thermo-sensitive transfer printing sheet according to the present invention;

Figure 2 is a schematic view showing transfer printing utilising the photo- and thermo-sensitive transfer printing sheet of Figure 1;

Figure 3 is a schematic sectional view through a second embodiment of photo- and thermo-sensitive transfer printing sheet according to the present invention;

Figure 4 is a schematic view showing transfer printing utilising the photo- and thermo-sensitive transfer printing sheet of Figure 3;

Figure 5 is a graph showing colour development characteristics of the Figure 3 transfer printing sheet;

Figure 6 is a schematic sectional view through a third embodiment of photo- and thermo-sensitive transfer printing sheet according to the present invention;

Figure 7 is a schematic view showing transfer printing utilising the photo- and thermo-sensitive transfer printing sheet of Figure 6; and

Figure 8 is a graph showing colour development characteristics of the Figure 6 transfer printing sheet.

Referring initially to Figures 1 and 2, a first embodiment of photo- and thermo-sensitive transfer sheet according to the present invention has a substrate 2 composed of a heat resistant film, such as polyethylene terephthalate (PET) having a thickness of the order of 10 $\mu m$. A lower micro-capsule layer 10 is formed on the substrate 2, and comprises porous micro-capsules 3, which contain leuco dye 4 and which are dispersed in a heat meltable binder 5. Further, an upper photo-sensitive layer 11 is formed on the micro-capsule layer 10, and comprises a mixture of a photo-sensitive resin 6, which is cured upon exposure to ultra-violet light or visible light 8, a photo-polymerisation initiator 7 effective to initiate photo-polymerisation of the photo-sensitive resin, and a binder. The porous micro-capsules 3 are capable of releasing the leuco dye 4 in response to thermal energy. On the other hand, the photo-sensitive resin 6 is capable of controlling transfer of the leuco dye 4 released from the micro-capsules 3 depending on the degree of photo-polymerisation due to irradiation by the light 8. Consequently, the amount of the leuco dye 4 transferred can be effectively controlled according to the radiation energy of the irradiating light 8. The two layers 10 and 11 thus effectively comprise a photo- and thermo-sensitive film having a double layer structure.

For example, when the ultra-violet or visible light 8 is modulated according to a video signal from a CRT, and is directed onto the photo-sensitive layer 11, portions 9 of the layer 10 of the photo-sensitive resin 6 are locally polymerised and cured to control the transfer of the leuco dye 4 which is released from the porous micro-capsules 3. As shown in Figure 2, heating is carried out by a heater 15, the micro-capsule layer 10 is melted, and the micro-capsules 3 begin to release the leuco dye 4. The released leuco dye 4 is transferred to recording paper 23 coated with developer 13. The transfer is controlled by the locally polymerised portions 9 of the photo-sensitive layer 11. Accordingly, the leuco dye 4 is transferred to the recording paper 12 according to area energy distribution of the irradiating light to form coloured portions 14 and to effect transfer printing of a high quality image with continuous gradation. Namely, gradation is obtained according to the radiation energy of the incident irradiating light on the sheet 1.

Figures 3 and 4 show a second embodiment of photo-and thermo-sensitive transfer sheet according to the present invention. As shown in these Figures, there is provided a substrate 102 composed of a heat

resistant film, such as polyethylene terephthalate (PET) having a thickness of the order of 10 μm. A micro-capsule layer 110 is formed on the substrate 102, and comprises porous micro-capsules 103, which contain colour dye or pigment 104 and which are dispersed in a heat meltable binder 105. Further, a photo-sensitive layer 111 is formed on the micro-capsule layer 110, and comprises a mixture of a photo-sensitive resin 106, which can be cured upon exposure to ultra-violet light or visible light 108, a photo-polymerisation initiator 107 effective to initiate photo-polymerisation of the photo-sensitive resin, and a binder. The porous micro-capsules are capable of releasing the colour dye or pigment in response to thermal energy. On the other hand, the photo-sensitive resin 106 is capable of controlling the transfer of the colour dye or pigment released from the micro-capsules depending on the degree of the photo-polymerisation due to the irradiation by light. Consequently, the transfer of the colour dye or pigment can be effectively controlled according to the radiation enery of the irradiating light.

For example, when the ultra-violet or visible light 108 is modulated according to a video signal from a CRT and is directed onto the photo-sensitive layer 111, the photo-sensitive resin 106 is locally polymerised and cured in portions 109 to control the transfer of the colour dye or pigment 104 which is released from the porous micro-capsules 103. As shown in Figure 4, heating is carried out by a heater 114, the micro-capsule layer 110 is melted, and the micro-capsules 103 begin to release the colour dye or pigment 104. The released colour dye or pigment 104 is transferred to plain recording paper 112. The transfer is controlled by the locally polymerised portions 109 of the photo-sensitive layer 111. Accordingly, the colour dye or pigment is transferred to the recording paper 112 according to area energy distribution of the irradiating light to form coloured portions 113 whereby to effect transfer printing of a high quality image with continuous gradation. Namely, gradation is obtained according to the radiation energy of the incident irradiating light.

## EXAMPLE 1

There was provided a colour dye SOT PINK-1 (C. I. Solvent Red 49: product of Hodogaya Chemical Industry (O., Ltd)). A 0.5 part by weight of the colour dye was dissolved into 60 parts by weight of oil, and a further 5 parts by weight of terephthalic acid dichloride was dissolved therein to form a capsule solution. This capsule solution was agitated within 3% (W/W) of PVA aqueous solution (KURAREPOVALL 224) by a homogeniser at 5000 rpm to form emulsion. Thereafter, while cooling the emulsion at 5°C and agitating it slightly, a solution containing 2.93 parts by weight of diethylenetriamine and 3 parts by weight of sodium carbonate dissolved in 23.3 parts by weight of water was gradually added to the emulsion to form micro-capsules according to the interfucial polymerisation method. The thus obtained 10 parts by weight of the micro-capsules containing the colour dye was dispersed into 10 parts by weight of 5% (W/W) PVA aqueous solution. This dispersion was coated on a substrate of PET film and then dried to form the micro-capsule layer 110.

Next, there was provided 1 part by weight of pentaerythritol tetracinnamate as the photo-sensitive resin 106, and there was provided 0.1 part by weight of benzoin as the photo-polymerisation initiator 107. These substances were dispersed into 5 parts by weight of the PVA aqueous solution. This dispersion was coated on the micro-capsule layer 110 to form the photo-sensitive layer 111, thereby producing the photo- and thermo-sensitive sheet 101 having the photo- and thermo-sensitive film with the double layer structure composed of the photo-sensitive layer 111 and the micro-capsule layer 110.

This photo- and thermo-sensitive transfer sheet was exposed by irradiation with ultra-violet light by a 300 W Xenon lamp. The thermal transfer to the recording sheet 112 was carred out by the heater 114 in the form of a thermal head. The developed colour density was measured over a portion corresponding to the ultra-violet light irradiated portion of the transfer sheet. The measurement results are shown in Figure 5 by the solid line. As described, the photo-sensitive layer 111 was formed on the micro-capsule layer 110. By selective irradiation of the photo-sensitive layer 111 with optical energy, the amount of the colour dye or pigment 104 contained in the porous micro-capsules 103 transferred was controlled so as to print a continuously gradated image on plain paper at a high quality.

## EXAMPLE 2

In a manner similar to Example 1, porous micro- capsules 103 containing colour dye SOT YELLOW-3

(C. I. Solvent Yellow 16: product of Hodogaya Chemical Industry (0., Ltd)) instead of SOT PINK-1 were formed. 2 parts by weight of cinnamic acid vinyl as the photo-sensitive resin 106 and 0.1 part by weight of benzophenone as the photo-polymerisation initiator 107 were utilised to form the photo- and thermo-sensitive transfer sheet 101.

The developed colour density was measured in a manner similar to that of Example 1, and the results are shown by the chain dotted line in Figure 5. As shown in Figure 5, continuous gradation can be obtained according to the amount of light energy applied, in terms of irradiation or exposure duration.

## EXAMPLE 3

In a manner similar to Example 1, porous micro-capsules containing colour dye SOT BLUE-1 (C. I. Solvent Blue 25: product of Hodogaya Chemical Industry (0., Ltd)) instead of SOT PINK-1 were formed. 1 part by weight of pentaerythritol tetracinnamate and 0.3 parts by weight of phenanthraquinon were utilised as the photo-sensitive resin 106 and the photo-polymerisation initiator 107 to form the photo- and thermo-sensitive transfer sheet 101.

In a manner similar to that of Example 1, the developed colour density was measured and the results are shown by the dashed line in Figure 5. As shown in Figure 5, continuous gradation of the colour density was obtained according to the duration of the irradiation.

Figures 6 and 7 show a third embodiment of the photo- and thermo-sensitive transfer sheet according to the present invention. In this instance, the photo-and thermo-sensitive transfer printing sheet 201 comprises a substrate 202 made of, for example, PET film, and a micro-capsule layer 210 formed on the substrate 202. The micro-capsule layer 210 comprises porous micro-capsules 203 containing leuco dye 204, photo-sensitive resin 206, a photo-polymerisation initiator 207 and a heat meltable binder 205 in which the micro-capsules, resin and initiator are dispersed. The photo-sensitive resin 206 is selectively cured by irradiation by ultra-violet light or by visible light 208 to form cured portions 209 in the layer 210 to produce a latent image. By heating with a heat generator 214, the micro-capsule layer 210 is melted so that the micro-capsules 203 release the leuco dye 204. The leuco dye 204 is transferred through the non-cured portions of the layer 210 to a recording sheet 211 to react with developer 212 coated on the recording sheet 211 to form a colour developed portion 213 thereby effecting thermal transfer printing. Depending on the degree of the photo-polymerisation, the cured state of the cured portions 209 is varied to control the transfer rate of the leuco dye 204 to effect transfer printing of a continuously gradated image of high quality.

## EXAMPLE 4

There was provided a dispersion composed of 10 parts by weight of aqueous solution of 5% (W/W) polyvinylalcohol (PVA) containing the following components:
10 parts by weight of porous micro-capsules containing magenta leuco dye:
1 part by weight of pentaerythritol tetracinnamate:
0.1 part by weight of benzionmethylether (BME).
This dispersion was coated on the substrate 202 of PET film and fully dried to produce the single layer photo-and thermo-sensitive film. The transfer sheet 201 was irradiated with ultra-violet light by a 300 W Xenon lamp. Thereafter, thermal transfer printing to the recording sheet 211 coated with the developer 212 was carried out by means of a thermal head.

The solid line in Figure 8 shows the relation between the irradiation time by the ultra-violet light and the colour development density of a portion corresponding to the ultra-violet light irradiated area. As shown, the transfer rate of the leuco dye is controlled according to the radiation energy to effect printing of a continuously gradated image.

## EXAMPLE 5

In a manner similar to Example 4, the photo- and thermo-sensitive transfer sheet 201 was produced using the following composition:

10 parts by weight of porous micro-capsules containing cyan leuco dye:
2 parts by weight of vinyl cinnamate:
0.1 part by weight of benzophenone.
The colour density was measured in a manner similar to that of Example 4. The results are shown by the chain dotted line in Figure 8. As shown, continuous gradation printing is available as in Example 4.

## EXAMPLE 6

In a manner similar to Example 5, the photo- and thermo-sensitive transfer printing sheet 201 was produced using the following composition:
10 parts by weight of porous micro-capsules containing yellow leuco dye:
1 part by weight of vinyl cinnamate:
0.1 part by weight of BME.
Similar measurements were carried out and the results are shown by the chain double-dotted line in Figure 8. The continuous gradation of the colour density was observed in a similar manner to Example 4.

For producing the micro-capsules used in the present invention, there can be employed various micro-encapsulation methods such as, for example, coacervation, in situ monomer polymerisation, spray drying, and inorganic wall micro-encapsulation. In particular, inter-facial polymerisation and the in situ monomer polymerisation are preferred for forming porous membranes of the micro-capsules.

Examples of substances which may be employed to form the porous membrane of the micro-capsules used in the present invention include polyamide, polyester, polyurea, polyurethane, urea-formaldehyde resin, melamine resin, etc.

The leuco dye can be selected from the following: crystal violet lactone, rhodamine B lactam, malachite green, 3-dialkylamino-7-dialkylamylfluorane, and benzoyl leuco methylene blue, etc.

The colour dyes may include monoazo derivatives, diazo derivatives, monoazo derivatives of metal complex salt type, anthraquinone derivatives, phthalocyanine derivatives and triallylmethane etc. For example, red colour dyes include C.I. Acid Red 87 and C.I. Solvent Red 8. Blue colour dyes include C.I. Basic Blue 5, C.I. Basic Blue 7, C.I. Basic Blue 9, C.I. Basic Blue 26, C.I. Acid Blue 1, and C.I. Solvent Blue 2. Yellow colour dyes include C.I. Basic Yellow 2, C.I. Basic Yellow 2, C.I. Acid Yellow 3, C.I. Acid Yellow 23, and C.I. Solvent Yellow 19, etc.

Various colour tone pigments can be utilised:

For example, red colour pigments include colcothar, cadmium red, cadmium-mercury red, antimony red, permanent red 4R, para red, fire red, parachlorcorthaniline red, lithol fast scarlet G, brilliant fast scarlet, vermilionettes, brilliant carmine BS, permanent red F2R, permanent red FRL, permanent red FRLL, permanent red F4RH, fast scarlet VD, vulcan fast rubin B, vulcan fast pink G, light fast red toner B, light fast red toner R, permanent FB, pyrazolone red, lithol red, lake red C, lake red D, anthocine B, brilliant scarlet G, lithol rubin GK, permanent red F5R, brilliant carmine 6B, pigment scarlet 3B, bordeaux 5B, toluidine maroon, permanent bordeaux F2R, helio bordeaux BL, bordeaux 10B, eosin lake, rhodamine lake B, rhodamine lake Y, alizarin lake, thioindigo red B, thioindigo maroon, permanent red FGR, PV carmine HR, monolite fast red YS, and permanent red BL.

Blue colour pigments include ultramarine blue, iron blue, cobalt blue, cerulean blue, alkali blue lake, peacock blue lake, victoria blue, non-metal phthalocyanine blue, phthalocyanine blue, fast sky blue, indanthren blue RS, indanthren blue BC and indigo.

Yellow colour pigments include chromic yellow, zinc yellow, barium chromate, cadmium yellow, yellow iron oxide, loess, titanium yellow, lead cyanamide, calcium metaplumbate, naphthol yellow S, Hanza yellow 10G, Hanza yellow G, Hanza yellow GR, Hanza yellow A, Hanza yellow RN, Hanza yellow R, pigment julome benzidine yellow GR, permanent yellow NCG, vulcan fast yellow 5G, vulcan fast yellow R, tartrazine lake, quinoline yellow lake, anthragen yellow 6GL, permanent yellow FGL, permanent yellow M10G, permanent yellow HR, and anthrapyrimidine.

The photo-sensitive resin may be composed of monomers of pentaerythritol derivatives as follows:

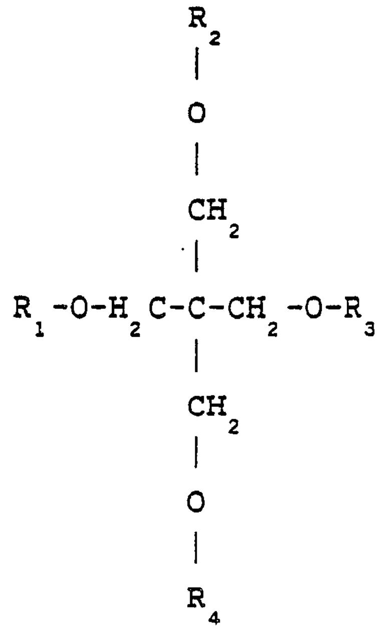

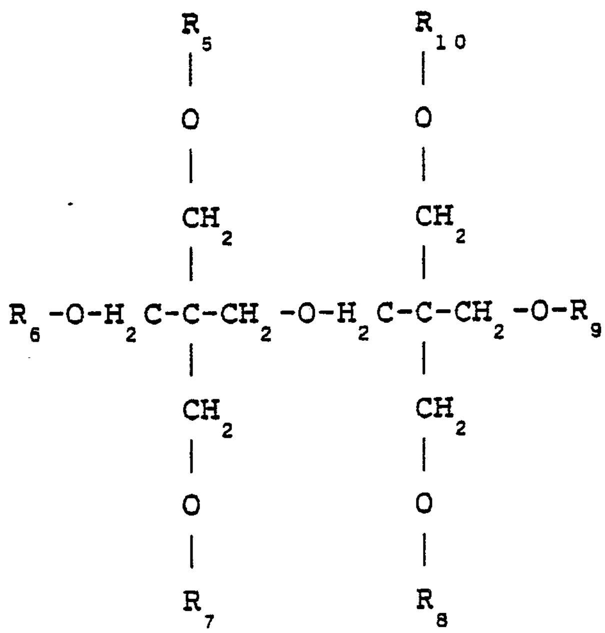

where $R_1$ to $R_{10}$ denote acrylic group or methacrylic group. Further, there may be included monomers of cinnamic acid esters and vinylamide derivatives as follows:

$C_6H_5\text{-}CH=CH\text{-}COOR_{11}$

$CH_2=CHCONH(CH_2)_nNHCOCH=CH_2$

where $R_{11}$ denotes alkyl group.

The photo-polymerisation initiator can be selected from the group consisting of quinone, acyloin, diazoanthrone, diazonium salt, diazophenanthrene, disulfide, aromatic azide, aromatic ketone, aromatic azosulfonate, and aromatic carbazide.

Preferably, the quinone is selected from: 0-benzoquinone, p-benzoquinone, 0-naphthoquinone, p-naphthoquinone, phenanthrenequinone, and anthraquinone. These quinones may not have a substitution group, or may have one of the following substitution groups: first, second or third alkyl, alkenyl and alkynyl, aryl, alkoxy, aryloxy, alkylaryloxy, hydroxyalkyl, hydroxyalkoxy, alkoxyalkyl, acyloxyalkyl, aryloxyalkyl, alkylcarbonyl, carbonyl, first or second amino, aminoalkyl, amidealkyl, anilino, piperidino, pyrrolidino, morpholino, nitro and halide. These listed groups are not limitative.

Typically, a quinone used in combination with a separate source of active hydrogen atom can be

selected from the following:
2,5-dimethyl-1,4-benzoquinone,
2,6-dimethyl-1,4-benzoquinone,
duroquinone,
2-(1′-formal-1-methylethyl)-5-methyl-1,4-benzoquinone,
2-methyl-1,4-benzoquinone,
2-phenyl-1,4 benzoquinone,
2,5-dimethyl-6-(1-formylethyl)-1,4-benzoquinone,
2-(2-cyclohexanoyl)-3,6-dimethyl-1,4-benzoquinone,
1,4 naphthoquinone,
2-methyl-1,4 naphthoquinone,
2,3-dimethyl-1,4-naphthoquinone,
2,3-dichloro-1,4 naphthoquinone,
2-thiomethyl-1,4-naphthoquinone,
2-(1-formyl-2-propyl)-1,4-naphthoquinone,
9,10-phenanthrenequinone,
2-t-butyl-9,10 anthraquinone,
2-methyl-1,4-anthraquinone, and
2-methyl-9,10-anthraquinone.

A preferred quinone having an internal hydrogen source is 5,8-dihydro-1,4-naphthoquinone having at least one hydrogen atom at the fifth or eighth order of a ring. Another preferred quinone having an internal hydrogen source is of the type in which a hydrogen atom is bonded to a carbon atom, an oxygen atom of a substitution oxy group or a nitrogen atom of a substitution amine group is bonded to the carbon atom, and further the bonding of the carbon atom and the hydrogen is separated from at least one quinonecarbonyl double bond through three or four bonding lengths. A preferred substitutional group is 2-substitutional amino. For example, preferred quinones are 1,4-benzoquinone and naphthoquinone having at the second or third order one or more of the following groups:
1′-hydroxyalkyl, 2′-hydroxyalkyl, alkoxy, 1′-alkoxyalkyl, 2′-alkoxyalkyl, arylalkoxy, 1′-or 2′-acyloxyalkyl, aryloxyalkoxy, 1′-or2′-aminoalkyl, 1′-or2 -aroyloxyalkyl, alkylarylamino, dialkylamino, N,N-bis(1-cyanoalkyl)-amino, N-aryl-N-(1-cyanoalkyl)amino, N-alkyl-N-(1-cyanoalkyl)amino, N,N-bis(1-carboxyalkyl)amino, N-aryl-N-(1-carboalkoxyalkyl)amino, N-alkyl-N-(1-carboalkoxyalkyl)amino, N,N-bis(1-nitroalkyl)amino, N-alkyl-N-(1-nitroalkyl)amino, N-aryl-N-(1-nitroalkyl)amino, N,N-bis(1-acylalkyl)amino, N-alkyl-N-(1-acylalkyl)amino, N-aryl-N-(1-acylalkyl)amino, N-aryl-N-(1-acylalkyl)amino, pyrrolino, pyrrolidino, piperidino, and morpholino.

Still another preferred quinone having an internal hydrogen source is non-substituted 5,8-dihydro-1,4-naphthoquinone which has one or more of the above listed preferred quinone substitutional groups at the second and/or third order. Further, a fused ring may be contained in the quinone. Typical quinones having an internal hydrogen source may be selected from the following:
5,8-dihydro-1,4-naphthoquinone,
5,8-dihydro-2,5,8-trimethyl-1,4-naphthoquinone,
2,5-bis(dimethylamino)-1,4-benzoquinone,
2,5-dimethyl-3,6-bis(dimethylamino)-1,4-benzoquinone,
2,5-dimethyl-3,6-bispyrrolidino-1,4-benzoquinone,
2-ethoxy-5-methyl-1,4-benzoquinone,
2-6-dimethoxy-1,4-benzoquinone,
2-5-diethoxy-1,4-benzoquinone,
2-5-bis(2-methoxyethoxy)-1,4-benzoquinone,
2,5-bis(β-phenoxyethoxy)-1,4-benzoquinone,
2,5-diphenylethoxy-1,4-benzoquinone,
2,5-di-isopropoxy-1,4-benzoquinone,
1,1′-bis(5-methyl-1,4-benzoquinone-2-yl)diethylether,
2-ethyl-5-morpholinomethyl-1,4-benzoquinone,
2,3,5-trimethyl-6-morpholinomethyl-1,4-benzoquinone,
2-hydroxymethyl-3,5,6-trimethyl-1,4-benzoquinone,
2- 1-hydroxyethyl)-5-methyl-1,4-benzoquinone,
2-(1-hydroxy-n-propyl)-5-methyl-1,4-benzoquinone,
2-(1-acetoxyethyl)-5-methyl-1,4-benzoquinone,
2-(2-hydroxyethyl)-3,5,6-trimethyl-1,4-benzoquinone,
2-ethoxy-5-phenyl-1,4-benzoquinone,

1,4-dihydro-1,4-dimethyl-9,10-anthraquinone,
2-dimethylamino-1,4-naphthoquinone,
2-methoxy-1,4-naphthoquinone,
2-benzoyloxy-1,4-naphthoquinone,
2-methoxy-3-chloro-1,4-naphthoquinone,
2,3-dimethoxy-1,4-naphthoquinone,
2-ethoxy-1,4-naphthoquinone,
2-(2-methoxyethoxy)-1,4-naphthoquinone,
2-(2-phenoxy)ethoxy-1,4-naphthoquinone,
2-ethoxy-5-methoxy-1,4-naphthoquinone,
2-n-propoxy-1,4-naphthoquinone,
2-(3-hydroxypropoxy)-1,4-naphthoquinone,
2-isopropoxy-1,4-naphthoquinone,
7-methoxy-2-isopropoxy-1,4-naphthoquinone,
2-n-butoxy-1,4-naphthoquinone,
2-sec-butoxy-1,4-naphthoquinone,
2-n-pentoxy-1,4-naphthoquinone,
2-acetoxymethyl-3-methyl-1,4-naphthoquinone,
2-($\beta$-acetoxyethyl)-1,4-naphthoquinone,
2-N,N-bis(cyanomethyl)aminomethyl-3-methyl-1,4-naphthoquinone,
2-methyl-3-morpholinomethyl-1,4-naphthoquinone,
2-hydroxymethyl-1,4-naphthoquinone,
2-hydroxymethyl-3-methyl-1,4-naphthoquinone,
2-(1-hydroxyethyl)-1,4-haphthoquinone,
2-(2-hydroxyethyl)-1,4-naphthoquinone,
2-(1,1-dimethyl-2-hydroxyethyl)-1,4-naphthoquinone,
2-bromo-3-isopropoxy-1,4-naphthoquinone,
2-ethoxy-3-methyl-1,4-naphthoquinone,
2-chloro-3-piperidino-1,4-naphthoquinone,
2-morpholino-1,4-naphthoquinone,
2,3-dipiperidino-1,4-naphthoquinone,
2-benzylamino-3-chloro-1,4-naphthoquinone,
2-methyloxy carbonylmethoxy-1,4-naphthoquinone,
2-(N-ethyl-N-benzylamino)-3-chloro-1,4-naphthoquinone,
2-morpholino-3-chloro-1,4-naphthoquinone, 2-piperidino-3-chloro-1,4-naphthoquinone,
2-piperidino-3-chloro-1,4-naphthoquinone,
2-diethylamino-3-chloro-1,4-naphthoquinone,
2-diethylamino-1,4-naphthoquinone,
2-piperidino-1,4-naphthoquinone,
2-(2-hexyloxy)-1,4-naphthoquinone,
2-neo-pentyloxy-1,4-naphthoquinone,
2-(2-n-pentyloxy)-1,4-naphthoquinone,
2-(3-methyl-n-butoxy)-1,4-naphthoquinone,
2-(6-hydroxy-n-hexoxy)-1,4-naphthoquinone,
2-(6-hydroxy-n-hexoxy)-1,4-naphthoquinone,
2-ethoxy-3-chloro-1,4-naphthoquinone,
2-di(phenyl)methoxy-1,4-naphthoquinone,
2-(2-hydroxyethoxy)-3-chloro-1,4-naphthoquinone,
2-methyl-3-(1-hydroxymethyl)ethyl-1,4-naphthoquinone,
2-azetidino-3-chloro-1,4-naphthoquinone,
2-(2-hydroxyethyl)-3-bromo-1,4-naphthoquinone,
2,3-dimorpholino-1,4-naphthoquinone,
2-ethylamino-3-piperidino-1,4-naphthoquinone,
2-ethoxymethyl-1,4-naphthoquinone, and
2-phenoxymethyl-1,4-naphthoquinone.

2H-benzimidazole forms dihydro-benzimidazole upon irradiation by active radiation under the presence of a non-stable hydrogen atom, and hence may be utilised as the photo-polymerisation initiator. The effective 2H-benzimidazole may include compounds having an electron-accepting group such as halogen

atom, cyano group, carboxyl group, nitro group and carbonyl-containing group. It may be preferred to use 2H-benzimidazole having one or more electron-donating bases. Typically, the 2H-benzimidazole may be selected from the following:
2,2-dimethyl-2H-benzimidazole,
2,2-diethyl-2H-benzimidazole,
spiro(2H-benzimidazole-2,1′-cyclohexane),
dispiro(2H-benzimidazole-2,1′-cyclohexane-4,2″-2H-benzimidazole,
2,2-dibenzyl-2H-benzimidazole,
2,2-dimethyl-4-n-butyl-2H-benzimidazole,
2′-methylspiro(2H-benzimidazole-2,1′-cyclohexane),
2′,6′-dimethylspiro(2H-benzimidazole-2,1′-cyclohexane),
5-methylspiro(2H-benzimidazole-2,1′-cyclohexane),
5,6,5″,6″-tetramethyldispiro(2H-benzimidazole-2,1′-cyclohexane-4′,2″-2H-benzimidazole-2,1′-cyclohexane-4′,2″-2H-benzimidazole),
4-bromo-2,2-dimethyl-2H-benzimidazole,
5-chlorospiro(2H-benzimidazole-2,1′cyclohexane),
2,2-diethyl-4-trichloromethyl-2H-benzimidazole,
2′,3′,4′,5′,6′-pentachlorospiro(2H-benzimidazole-2,1′-cyclohexane),
5-trifluoromethylspiro(2H-benzimidazole-2,1′-cyclohexane),
2,2′-dibenzyl-4-methoxy-2H-benzimidazole,
2,2-diethyl-4-isopropoxy-2H-benzimidazole,
2,2-diethyl-5-ethoxy-2H-benzimidazole,
5-methoxyspiro(2H-benzimidazole-2,1′-cyclohexanone),
3′-neopentoxyspiro(2H-benzimidazole-2,1′-cyclohexane)
4,4′-dimethoxyspiro(2H-benzimidazole-2,1′cyclohexane-4′,2″-2H-benzimidazole),
2,2-dimethyl-4-amino-2H-benzimidazole,
2,2-dimethyl-5-(N-phenylamino)-2-benzimidazole,
2,2-dimethyl-5-(N-tolylamino)-2H-benzimidazole,
4-(N,N-diphenylamino)spiro(2H-benzimidazole-2,1′-cyclohexanone),
4-(N-phenylamino)spiro(2H-benzimidazole-2,1′-cyclohexane),
2′-mcrpholinospiro(2H-benzimidazole-2,1′-cyclohexane),
2,2-diphenyl-4-piperidino-2H-benzimidazole,
2,2-diphenyl-5-mthylazo-2H-benzimidazole,
2′-methylazospiro(2H-benzimidazole-2,1′-cyclohexane),
2,2-dimethyl-5-styryl-2H-benzimidazole,
5-vinylspiro(2H-benzimidazole-2,1′-cyclohexane),
2,2-diphenyl-5-nitro-2H-benzimidazole, and
5-carbomethoxyspiro(2H-benzimidazole-2,1′-cyclohexane.

Typically, disulfide, diazoanthrone, diazophenanthrene, aromatic carbuzide, aromatic azide, diazonium salts, and aromatic sulfonate may advantageously include the following:
1-naphthyldisulfide,
β-naphthyldisulfide,
9-anthryldisulfide,
cyclohexyl 2-naphthyldisulfide,
diphenylmethyl 2-naphthyldisulfide,
2-dedocyl 1′-naphthyldisulfide, thioctic acid,
2,2′-bis(hydroxymethyl)diphenyldisulfide,
10-diazoanthrone,
2-methoxy-10-diazoanthrone,
3-nitro-10-diazoanthrone,
3,6-diethoxy-10-diazoanthrone,
3-chloro-10-diazoanthrone,
4-ethoxy-10-diazoanthrone,
4-(1-hydroxyethyl)-10-diazoanthrone,
2,7-diethyl-10-diazoanthrone,
9-diazo-10-phenanthrone,
3,6-dimethyl-9-diazo-10-phenanthrone,
2,7-dimethyl-9-diazo-10-phenanthrone,

4-azidebenzoic acid,
4-nitrophenylazide,
4-dimethylaminophenylazide,
2,6-di-4-azidebenzylidene-4-methylcyclohexane,
2-azide-1-octylcarbamoylbenzimidazole,
2,5-bis(4-azidephenyl)-1,3,4-oxadiazole,
1-azide-4-methoxyhaphthalene,
2-carbazide-1-naphthole,
benzophenone,
2-nitrobenzophenone,
diaminobenzophenone,
naphthalophenone,
phenyl(1-methoxy benzyl)ketone,
phenyl-1-(1-phenoxy)benzylketone,
phenyl-1-(2-chlorophenoxy)benzylketone,
phenyl-1-(2-bromophenoxy)benzylketone,
phenyl-1-(2-iodephenoxy)benzylketone,
phenyl-1-(4-phenoxy)benzylketone,
phenyl-1-(4-benzoylphenoxy)benzylketone,
4-(diamylazide)benzene azonium tetrafluoroborate,
2-methyl-4-diethylaminobenzenediazoniumtetrafluoroborate,
4-(oxazolydino)benzenediazoniumtetrafluoroborate,
4-(cyclohexylamino)benzenediazoniumtetrafluoroborate,
2-nitro-4-morpholinobenzenediazoniumhexafluorophosphate,
4-(9-carbazoyl)benzenediazohiumhexafluorophosphate,
4-(dihydroxyethylamino)-3-methylbenzenediazoniumhexafluorophosphate,
4-diethylaminobenzenediazoniumhexachlorostannate,
4-dimethylamino-3-methylbenzenediazoniumhexachlorostannate,
2-methyl-4-(N-mcthyl-N-hydroxypropylamino)benzenediazoniumhexachlorostannate,
4-dimethylaminobenzenediazoniumtetrachlorozincate,
4-dimethylamino-3-ethoxybenzenediazoniumchlorozincate,
4-diethylaminobenzenediazoniumtetrachlorozincate,
4-diethylaminobenzenediazoniumhexafluorophosphate,
2-carboxy-4-dimethylaminobenzenediazoniumhexafluorophosphate,
3-(2-hydroxyethoxy)-4-pyrrolidinobenzenediazoniumhexafluorophosphate,
4-methoxybenzenediazoniumhexafluorophosphate,
2,5-diethoxy-4-acetoamidebenzenediazoniumhexafluorophosphate,
4-methylamino-3-ethoxy-6-chlorobenzenediazoniumhexafluorophosphate,
3-methoxy-4-diethylaminobenzenediazoniumhexafluorophosphate,
di(1-naphthyl) aklonine,
benzoin,
benzoinacetate,
benzoinmethylether,
benzoinphenylether,
benzoin2-bromophenylether,
benzoin4-chlorophenylether,
benzoin4-phenoxyphenylether,
benzoin4-benzoylphenylether,
benzoin2-iodephenylether,
benzoin2-chlorophenylether,
2-phenylbenzoin,
2-(1-naphthole) benzoin,
2-n-butylbenzoin,
2-hydroxymethylbenzoin,
2-(2-cyanoethyl)benzoin, and
2-(5-benthynil)benzoin.

Examples of the binder include polyvinyl alcohol, methyl cellulose, carboxymethyl cellulose, styrenbutadiene latex, etc.

The colour developer can be selected from the following: aromatic carboxylic acid metal salts of, for example, salicylic acid and its derivatives, clays such as acidic clay, activated clay and bentonite, and phenolic compounds such as α-naphthol, β-naphthol and bisphenol A.

## Claims

1. A transfer printing medium comprising a heat resistant substrate (2, 102, 202), and a thermo-sensitive film (10, 11, 110, 111, 210) disposed on the substrate, the film being composed of porous micro-capsules (3, 103, 203) which contain colouring material (4, 104, 204), and a binder (5, 105, 205) in which the micro-capsules are distributed, the film being responsive to thermal energy to release the colouring material, characterised in that the film is further composed of a photo-sensitive material (6, 7, 106, 107, 206, 207) and is responsive to exposure to light to control the transfer of the released colouring material during printing.

2. A transfer printing medium according to claim 1 characterised in that the photo-sensitive material comprises a resin (6, 106, 206) arranged to undergo photo-polymerisation in response to exposure to light, and an initiator (7, 107, 207) effective to initiate the photo-polymerisation.

3. A transfer printing medium according to claim 1 or 2 characterised in that the film comprises a first layer (10, 110) which is disposed on the substrate and which contains the porous micro-capsules, and a second layer (11, 111) which is disposed on the first layer and which contains the photo-sensitive material.

4. A transfer printing medium according to claim 1 or 2 characterised in that the film comprises a single layer (210) which contains the porous micro-capsules and the photo-sensitive material.

5. A transfer printing medium according to any preceding claim characterised in that the colouring material comprises leuco dye.

6. A transfer printing medium according to any of claims 1 to 4 characterised in that the colouring material comprises coloured dye.

7. A transfer printing medium according to any of claims 1 to 4 characterised in that the colouring material comprises pigment.

8. A transfer printing medium according to any preceding claim characterised in that the binder is heat meltable.

9. A transfer printing medium comprising a heat resistant substrate (2, 102, 202), and a thermo-sensitive film (10, 11, 110, 111, 210) disposed on the substrate, the film being composed of porous micro-capsules (3, 103, 203) containing colouring material (4, 104, 204) and thermo-sensitive to release the colouring material, and a binder (5, 105, 205) in which the micro-capsules are distributed, characterised in that the film is further composed of a resin (6, 106, 206) photo-sensitive to undergo photo-polymerisation to control transfer rate of the released colouring material, and an initiator (7, 107, 207) effective to initiate the photo-polymerisation, the resin and the initiator being distributed in the binder.

FIG.1

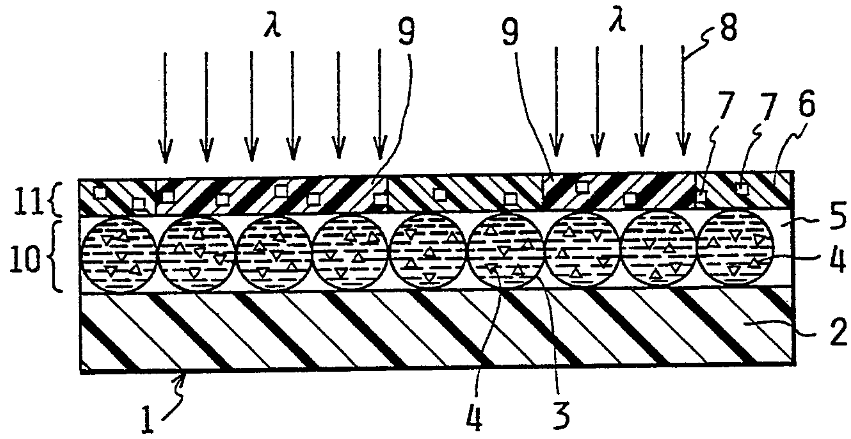


FIG.2

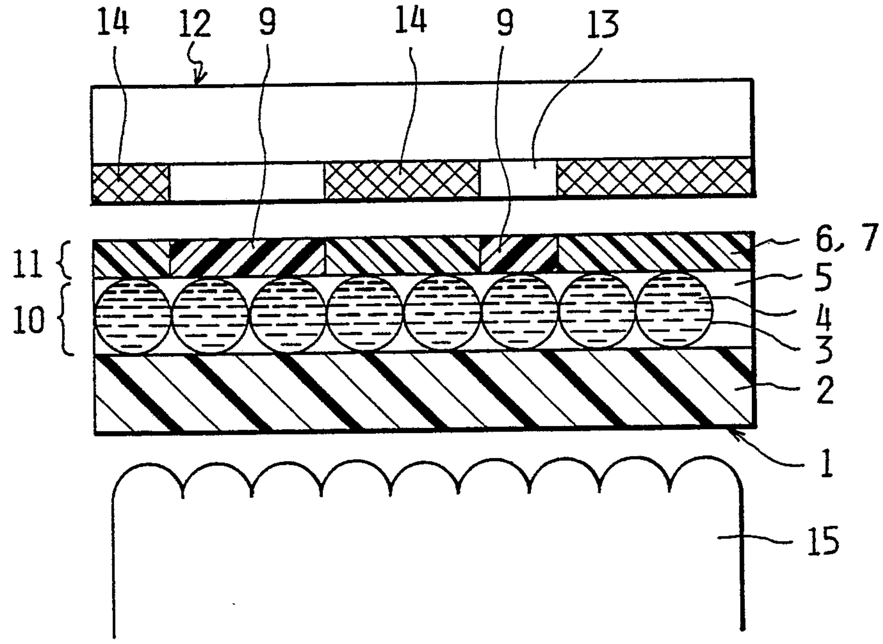

FIG. 3

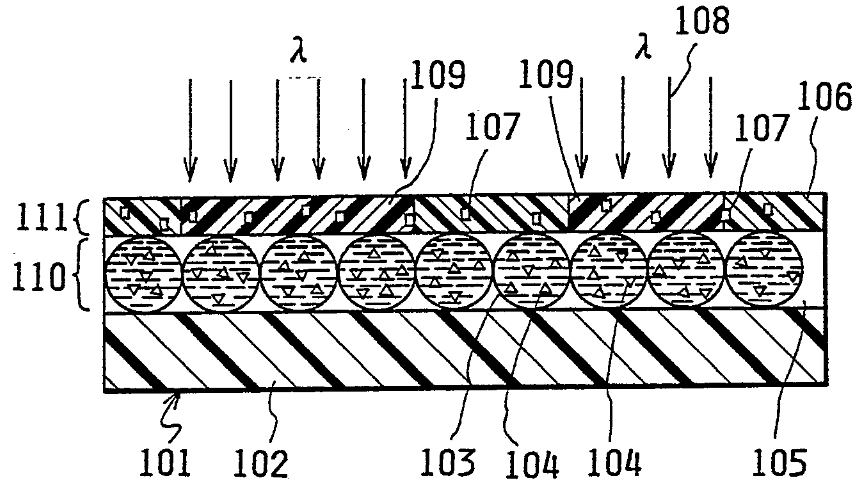
λ
λ
108
109
109
106
107
107
111
110
101
102
103
104
104
105

FIG. 4

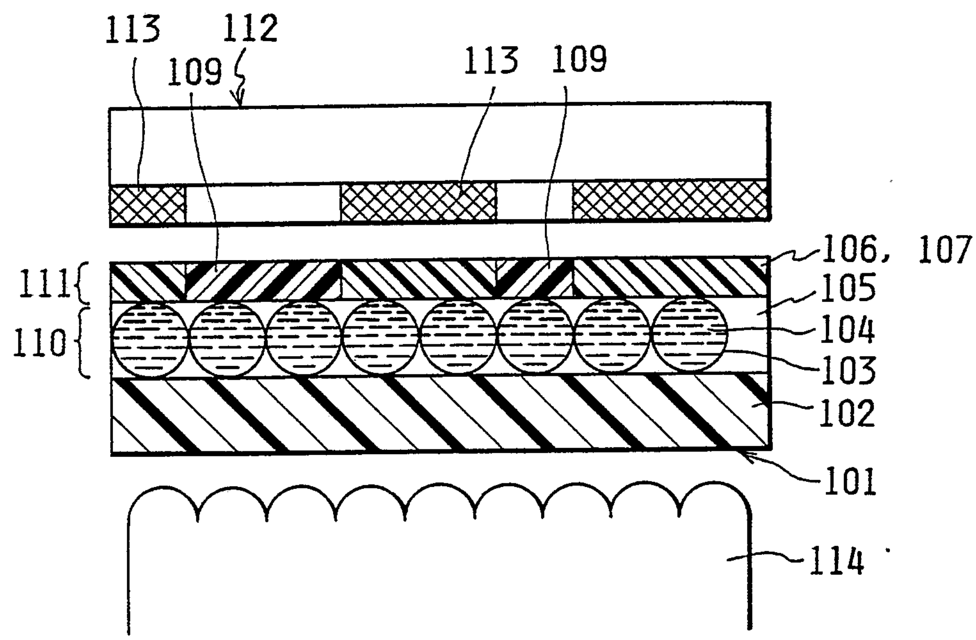
113
112
109
113
109
106, 107
105
111
110
104
103
102
101
114

FIG.5

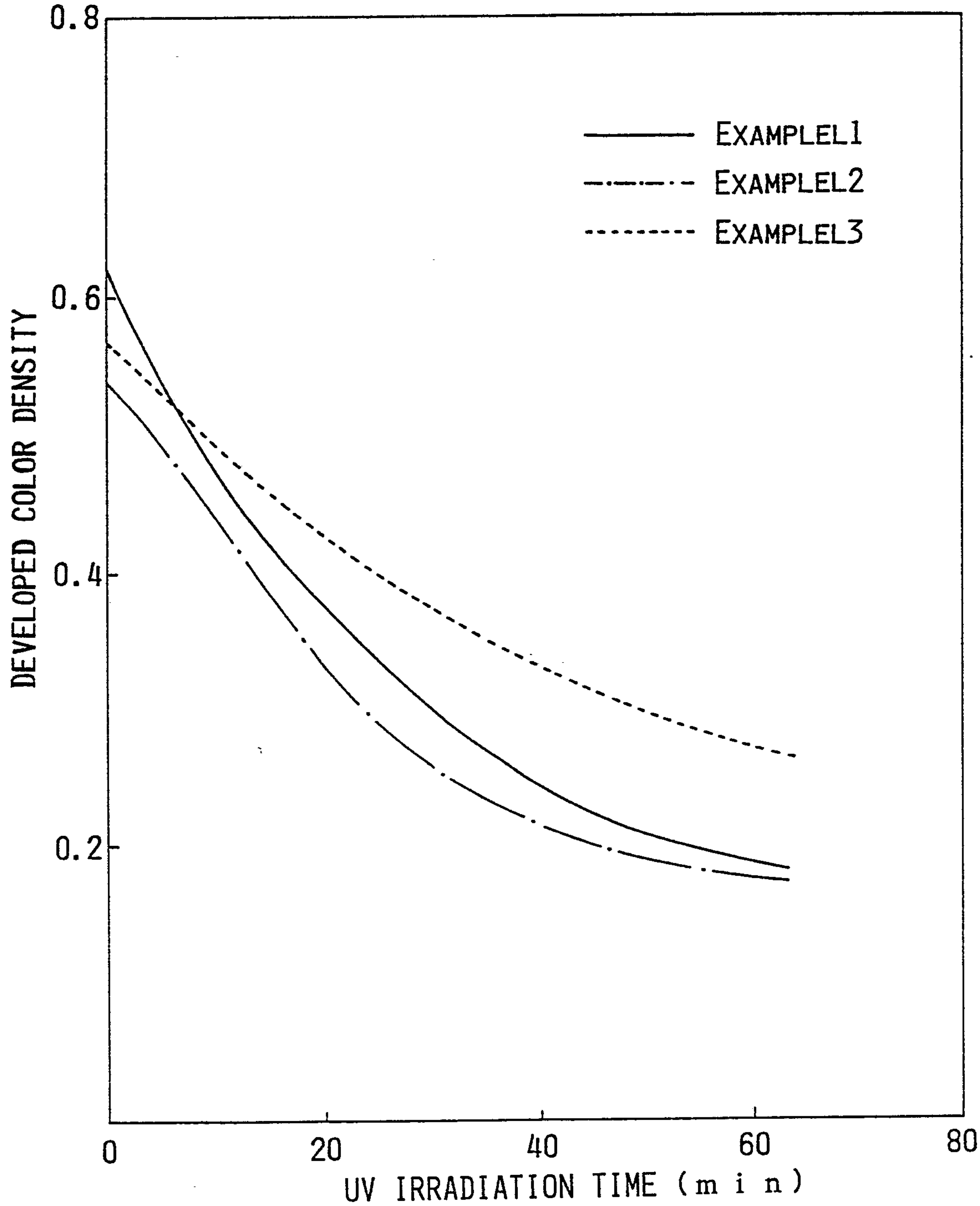
0.8
0.6
0.4
0.2
DEVELOPED COLOR DENSITY
EXAMPLEL1
EXAMPLEL2
EXAMPLEL3
0
20
40
60
80
UV IRRADIATION TIME (m i n)

FIG.6

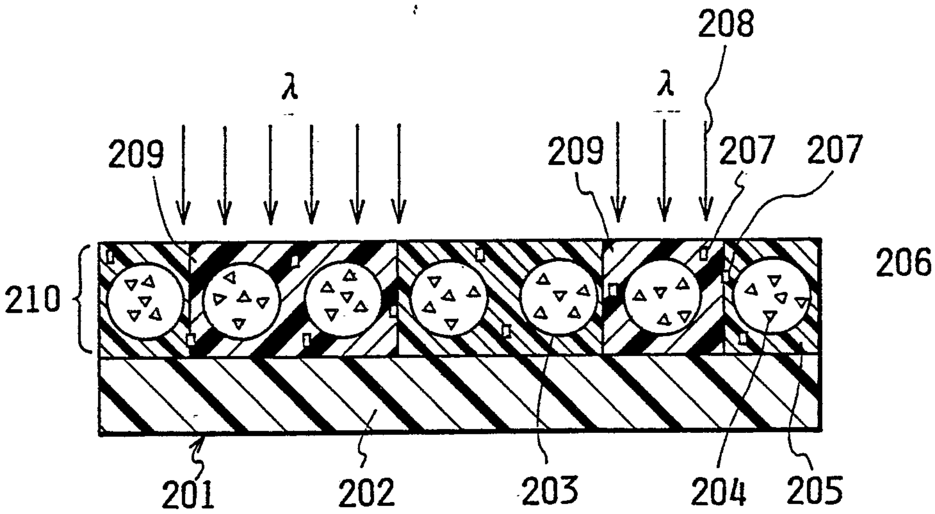
208
λ
λ
209
209
207
207
206
210
201
202
203
204
205

FIG.7

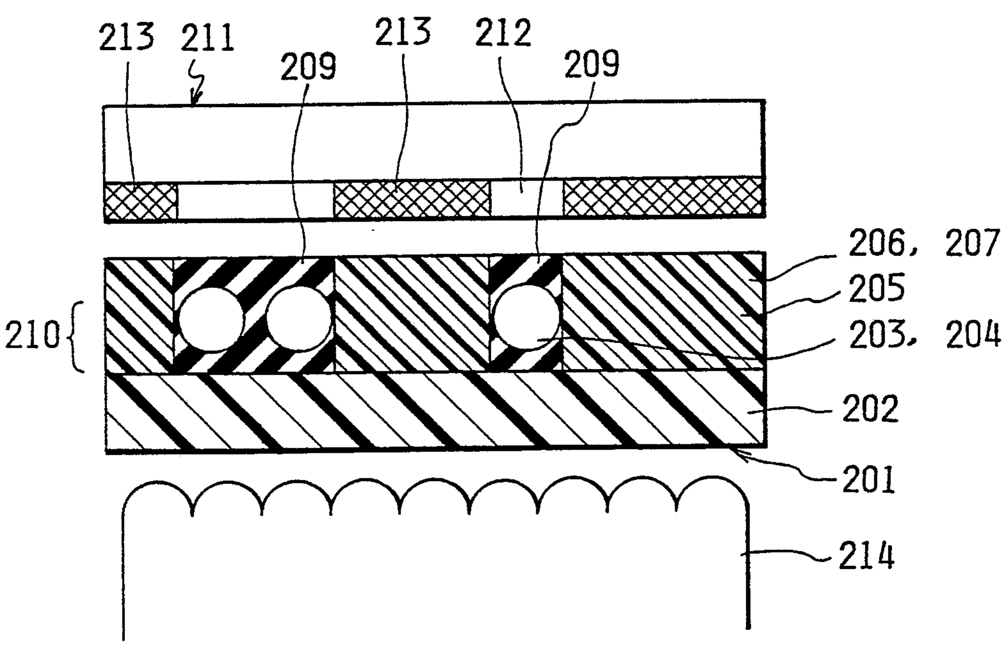
213
211
213
212
209
209
206, 207
205
210
203, 204
202
201
214

FIG. 8

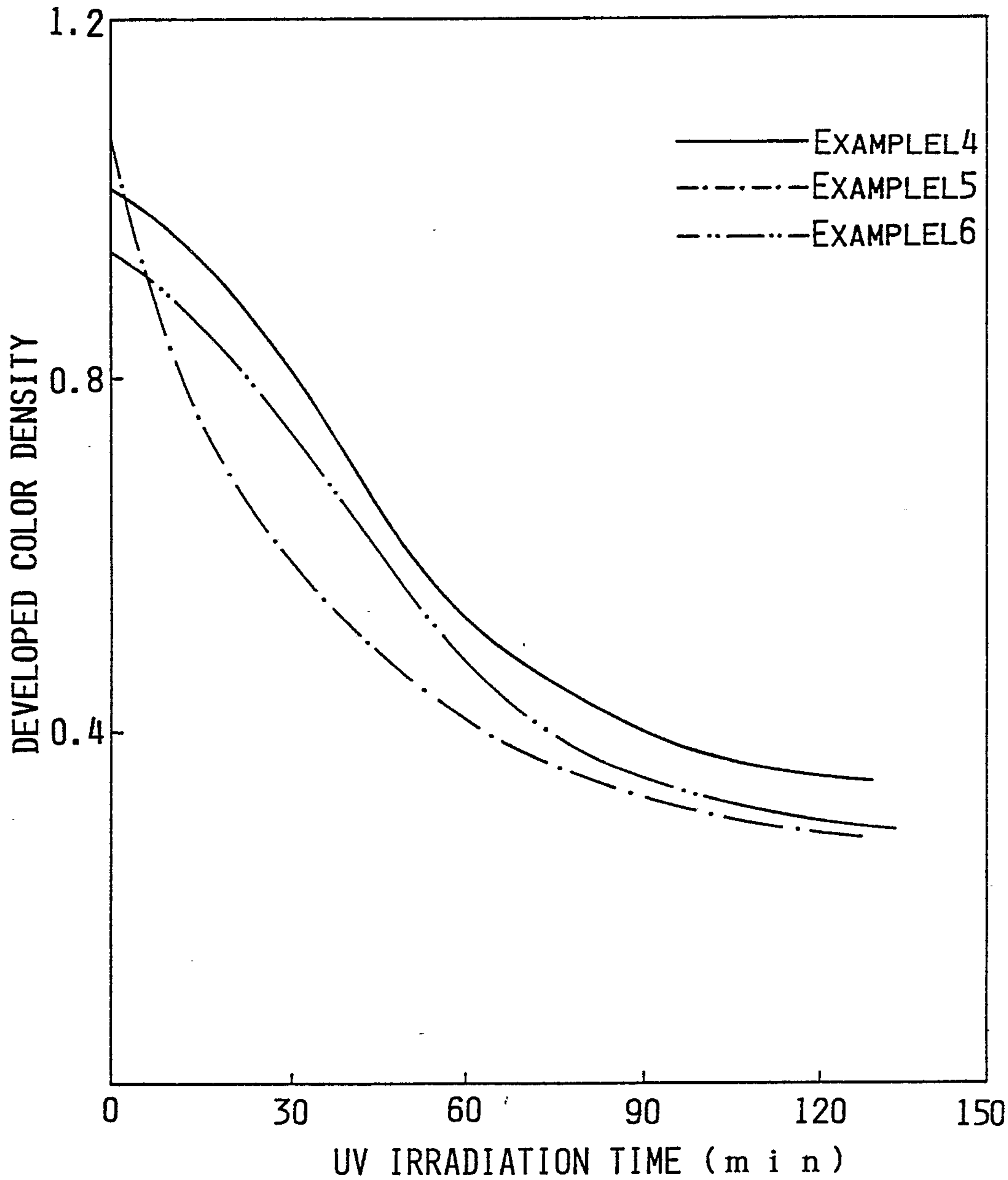
1.2
0.8
0.4
DEVELOPED COLOR DENSITY
0
30
60
90
120
150
UV IRRADIATION TIME (min)
EXAMPLEL4
EXAMPLEL5
EXAMPLEL6